(19) Europäisches Patentamt / European Patent Office / Office européen des brevets

(11) **EP 3 156 811 B1**

(12) **EUROPEAN PATENT SPECIFICATION**

(45) Date of publication and mention
of the grant of the patent:
**09.09.2020 Bulletin 2020/37**

(51) Int Cl.:
***G01R 31/34*** *(2020.01)*     ***H02P 29/024*** *(2016.01)*

(21) Application number: **15465551.8**

(22) Date of filing: **15.10.2015**

(54) **METHOD AND SYSTEM FOR DETECTING AN OPEN PHASE FAULT IN A MULTI-PHASE ELECTRIC MACHINE**

VERFAHREN UND SYSTEM ZUR DETEKTION EINES FEHLERS EINER OFFENEN PHASE IN EINER MEHRPHASIGEN ELEKTRISCHEN MASCHINE

PROCÉDÉ ET SYSTÈME POUR DÉTECTER UN DÉFAUT DE PHASE OUVERTE DANS UNE MACHINE ÉLECTRIQUE POLYPHASÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.04.2017 Bulletin 2017/16**

(73) Proprietor: **Vitesco Technologies GmbH
30165 Hannover (DE)**

(72) Inventor: **MOCANU, Razvan
705300 Tirgu Frumos, iud. Iasi (RO)**

(74) Representative: **Waldmann, Georg Alexander et al
Continental Automotive GmbH
Postfach 22 16 39
80506 München (DE)**

(56) References cited:
**EP-A1- 2 830 206     EP-A1- 2 913 918
JP-A- 2006 025 526     US-A1- 2011 089 883**

**Description**

The present application relates to a method and a system for detecting an open phase fault in a multi-phase electric machine and, in particular, to a method and a system for detecting an open phase fault in a multi-phase electric machine of a vehicle.

Electric machines, in particular electric motors, are widely used in many applications. Therein, most of the common low power electric motor actuated systems do not require a sophisticated fault detection means. However, in high power applications, for example in hybrid electric vehicles, where electric machines develop a large amount of power, the safety concerns must be much more rigorous. Therein, faults can for example occur due to onboard power electronic track failures or power socket connector damages.

Further, multi-phase motors, for example three-phase induction motors have been developed, which have a higher efficiency than single-phase induction motors of similar quality and are, therefore, suitable for high power applications.

Therein, an open phase of a three-phase motor is that one phase current on a three-phase motor may be lacked. Such an open phase fault could cause an over current on the other two motor phases which can lead to an unpredictable torque behavior, thereby for example threatening the safety of passengers in a hybrid electric vehicle. Therefore, open phase detection of the three-phase alternating currents is necessary.

Known methods for detecting an open phase fault of a three-phase motor are based on detecting a phase difference between the three-phase voltages or currents using a detection circuit. However, this detection circuit may comprise many components and, thus, may have a complex structure.

The document US 2011/0089883 A1 discloses a method of detecting a phase fault in a multi-phase electric machine, which is executable via a motor controller and includes measuring feedback signals of the machine, including each phase current, and generating reference phase voltages for each phase. The method includes calculating a predetermined voltage value using the feedback signals and reference phase voltages, and comparing the voltage value to a corresponding threshold to determine the fault. A control action is executed when the voltage value exceeds the corresponding threshold. The document JP 2006 025526 A discloses a phase interruption detection method of a power converter provided with a current detection machine for driving an alternative current motor. The document EP 2 913 918 A1 discloses a power conversion device and a fault phase detection method based on a current phase rotation coordinates output.

It is an object of the present application to provide an improved method for detecting an open phase fault in a multi-phase electric machine, which is feasible with a low number of hardware components and input parameters.

According to one embodiment of the invention, a method for detecting an open phase fault in a multi-phase electric machine is provided, wherein at least one current value of each phase of the multi-phase electric machine is measured, wherein, for always two phases of the multi-phase electric machine, a phase delay between the two phases is determined based on the measured current values, wherein it is determined if a determined phase delay between two phases exceeds a predetermined threshold, and wherein it is detected that there is an open phase fault, if a determined phase delay between two phases exceeds the predetermined threshold.

Thus, a method for detecting an open phase fault in a multi-phase electric machine is provided, which does not require any other input parameters than the phase currents and, therefore, is independent of any other input parameters. Thus, no additional hardware components are required to implement the method, except a phase current measurement device for measuring at least one current value of each phase of the multi-phase electric machine, optionally a respective acquisition device for converting the measured values into digital signals, and a processing device for processing the measured values in order to detect whether there is an open phase fault. Thus, an improved method for detecting an open phase fault in a multi-phase electric machine is provided, which is feasible with a low number of hardware components and input parameters.

Therein, the method can further comprise the step of transferring the multi-phase electric machine into a safe state, if it is detected that there is an open phase fault, thereby satisfying the safety concerns of the multi-phase electric machine. The step of transferring the multi-phase electric machine into a safe state can for example comprise to stop generating a driving signal for the multi-phase electric machine and/or to output corresponding alarm information.

Further, the step of measuring at least one current value of each phase of the multi-phase electric machine can comprise measuring a plurality of current values of each phase of the multi-phase electric machine. Thereby, the accuracy as well as the efficiency of the method for detecting an open phase fault in a multi-phase electric machine can be further improved, as the determination of a phase delay between two phases of the multi-phase electric machine can be based on a plurality of measured values. Therein, by dynamically processing the plurality of measured values, that is by directly processing a value of the plurality of measured values, when the value has been measured, the size of a memory required for storing the plurality of measured values can be reduced, too.

According to one embodiment, the step of, for always two phases of the multi-phase electric machine, determining a phase delay between the two phases based on the measured current values comprises calculating a cross-correlation coefficient between the plurality of current values of a first phase of the two phases and the plurality of current values of a second phase of the two phases, and calculating an arc-cosine of the calculated cross-correlation coefficient in order to obtain a phase angle between the two phases, and the step of determining if a determined phase delay between two phases exceeds a predetermined threshold comprises using a debouncing algorithm to determine whether the phase angle between the two phases and, thus, a phase angle delay, exceeds a specified angle for an amount of time. The cross-correlation coefficient is a quantity that gives the quality of a least squares fitting to the original data. In particular, the cross correlation coefficient is a measure of the linear correlation between two variables, here the measured current values of a first phase of the multi-phase electric machine and the measured current values of a second phase of the multi-phase electric machine, giving a value between +1 and -1 inclusive, where 1 is total positive correlation, 0 is no correlation, and -1 is total negative correlation, and wherein the correlation describes a relation between the two phases. Therein, by calculating the arc-cosine function of the cross correlation coefficient, the phase angle between the two phases can be calculated. Further, by using a debouncing algorithm afterwards, it can be detected if the previously calculated phase angle exceeds a specified angle for a specified amount of time and, thus, an open phase fault can be detected. In particular, in normal operation, the phase angles in a three-phase motor should be offset by an angle of 120°. Therefore, if a phase angle for example exceeds 180° for a specified amount of time, the other phases are opened and, therefore, there is an open phase fault. Thus, an open phase fault can be efficiently detected with little computational effort, as no coordinate transformation or other transformation of the measured values is required when processing the measured values and, thus, an algorithm for detecting an open phase fault with low complexity is provided.

According to another embodiment, the plurality of current values of each phase of the multi-phase electric machine are measured over a predetermined sampling period, wherein the step of, for always two phases of the multi-phase electric machine, determining a phase delay between the two phases based on the measured current values comprises calculating a cross-correlation between the plurality of current values of a first phase of the two phases and the plurality of current values of a second phase of the two phases, and maximizing the calculated cross correlation in order to obtain a phase time delay between the two phases. In signal processing, cross-correlation is a measure of similarity of two series as a function of the lag of one relative to the other, here the phase time delay between a first phase of the multi-phase electric machine and a second phase of the multi-phase electric machine. Thus, an open phase fault can again be efficiently detected with little computational effort, as no coordinate transformation or other transformation of the measured values is required when processing the measured values, and, thus, an algorithm for detecting an open phase fault with low complexity is provided, wherein only the measured phase currents as well as the predetermined sampling period are required as input parameters.

Therein, the predetermined sampling period can be based on a maximum frequency of the multi-phase electric machine. During normal operation, the electromagnetic flux in a multi-phase electric machine, for example a three-phase motor of a hybrid electric vehicle, is not constant and must be built for every stroke. In the motoring period, these strokes correspond to the rotor position when the rotor poles are approaching the corresponding stator pole of the excited phase. Thus, by basing the predetermined sampling period on a maximum frequency of the multi-phase electrical machine, for example by establishing a linear relationship between the predetermined sampling period and the maximum frequency of the multi-phase electrical machine, this effects can be taken into consideration and, thus, the accuracy as well as the efficiency of the method for detecting an open phase fault in a multi-phase electric machine can be further enhanced.

According to another embodiment of the invention, a computer program product is provided, which comprises code tangibly embodied thereon, that when executed on a processor, causes the processor to perform a method for detecting an open phase fault in a multi-phase electric machine as described above.

Therefore, a computer program product is provided, which comprises code tangibly embodied thereon, that when executed on a processor, causes the processor to perform a method for detecting an open phase fault in a multi-phase electric machine, wherein no other input parameters than the phase currents are required and wherein the method is independent of other input parameters. Thus, a computer program product which embodies an improved method for detecting an open phase fault in a multi-phase electric machine, which is feasible with a low number of input parameters, is provided.

According to still another embodiment of the invention, a system for detecting an open phase fault in a multi-phase electric machine is provided, which comprises a phase current measurement device coupled to the multi-phase electric machine for measuring at least one current value of each phase of the multi-phase electric machine and an electronic control unit for detecting an open phase fault in the multi-phase electric machine, wherein the electronic control unit comprises a first determining means for determining, for always two phases of the multi-phase electric machine, a phase delay between the two phases based on the measured current values, a second determining means for determining if a determined phase delay between two phases exceeds a predetermined threshold, and a detecting means for detecting that there is an open phase fault if a determined phase delay between two phases exceeds a predetermined threshold.

Thus, a system for detecting an open phase fault in a multi-phase electric machine is provided, which does not require any additional hardware components to facilitate the detection of an open phase fault in a multi-phase electric machine, except a phase current measurement device for measuring at least one current value of each phase of the multi-phase electric machine, optionally a respective acquisition device for converting the measured values into digital signals, and an electronic control unit for processing the measured values in order to detect whether there is an open phase fault. Furthermore, no other input parameters than the phase currents are required to facilitate the detection of an open phase fault by the system. Thus, an improved system for detecting an open phase fault in a multi-phase electric machine is provided, which facilitates the detection of an open phase fault in a multi-phase electric machine with a low number of hardware components and input parameters.

Therein, the phase current measurement device can comprise at least one hall sensor and/or at least one shunt resistor, as hall sensors and shunt resistors are well known as low-cost, accurate and small-size sensor solutions for current measurement. That the phase current measurement device comprises at least one hall sensor and/or at least one shunt resistor should merely be understood as an example, however, and the phase current measurement device can comprise any other device capable of measuring at least one current value of a phase of a multi-phase electric machine, too.

The electronic control unit can further comprise a transferring means for transferring the multi-phase electric machine into a safe state, if an open phase fault is detected, thereby satisfying the safety concerns of the multi-phase electric machine. Therein, the transferring means can for example comprise a means for stopping generating a driving signal for the multi-phase electric machine and/or a warning means for outputting corresponding alarm information.

Also the phase current measurement device can be configured to measure a plurality of current values of each phase of the multi-phase electric machine. Thereby, the accuracy as well as the efficiency of the detection of an open phase fault in a multi-phase electric machine can be further improved, as the determination of a phase delay between two phases of the multi-phase electric machine can be based on a plurality of measured values. Further, by dynamically processing the plurality of measured values, that is by directly processing a value of the plurality of measured values, when the value has been measured, the size of a memory required for storing the plurality of measured values can be reduced, too.

According to one embodiment, the first determining means comprises a first calculating means for calculating a cross-correlation coefficient between the plurality of current values of a first phase of the two phases and the plurality of current values of a second phase of the two phases, and a second calculating means for calculating an arc-cosine of the calculated cross-correlation coefficient in order to obtain a phase angle between the two phases, and the second determining means is configured to use a debouncing algorithm to determine whether the phase angle between the two phases, and, thus, a phase angle delay, exceeds a specified angle for an amount of time. The cross-correlation coefficient is a quantity that gives the quality of a least squares fitting to the original data. In particular, the cross correlation coefficient, is a measure of the linear correlation between two variables, here the measured current values of a first phase of the multi-phase electric machine and the measured current values of a second phase of the multi-phase electric machine, giving a value between +1 and -1 inclusive, where 1 is total positive correlation, 0 is no correlation, and -1 is total negative correlation, and wherein the correlation describes a relation between the two phases. Therein, by calculating the arc-cosine function of the calculated cross correlation coefficient, the phase angle between the two phases can be calculated. Further, by using a debouncing algorithm afterwards, it can be detected if the previously calculated phase angle exceeds a specified angle for a specified amount of time and, thus, an open phase fault can be detected. In particular, in normal operation, the phase angles in a three-phase motor should be offset by an angle of 120°. Therefore, if a phase angle exceeds for example 180° for a specified amount of time, the other phases are opened and, therefore, there is an open phase fault. Thus, an open phase fault can be efficiently detected with little computational effort, as no coordinate transformation or other transformation of the measured values is required when processing the measured values, and, thus, an algorithm for detecting an open phase fault with low complexity is implemented.

According to another embodiment, the phase current measurement device is configured to measure the plurality of current values of each phase of the multi-phase electric machine over a predetermined sampling period, and the first determining means comprises a third calculating means for calculating a cross-correlation between the plurality of current values of a first phase of the two phases and the plurality of current values of a second phase of the two phases, and a fourth calculating means for maximizing the calculated cross correlation in order to obtain a phase time delay between the two phases. In signal processing, cross-correlation is a measure of similarity of two series as a function of the lag of one relative to the other, here the phase time delay between a first phase of the multi-phase electric machine and a second phase of the multi-phase electric machine. Thus, an open phase fault can again be efficiently detected with little computational effort, as no coordinate transformation or other transformation of the measured values is required when processing the measured values, and, thus, an algorithm for detecting an open phase fault which has low complexity is implemented, wherein only the measured phase currents as well as the predetermined sampling period are required as input parameters.

Therein, the predetermined sampling period can be based on a maximum frequency of the multi-phase electric machine. During normal operation, the electromagnetic flux in a multi-phase electric machine, for example a three-phase motor of a hybrid electric vehicle, is not constant and must be built for every stroke. In the motoring period, these strokes correspond to the rotor position when the rotor poles are approaching the corresponding stator pole of the excited phase.

Thus, by basing the predetermined sampling period on a maximum frequency of the multi-phase electrical machine, for example by establishing a linear relationship between the predetermined sampling period and the maximum frequency of the multi-phase electrical machine, this effects can be taken into consideration and, thus, the accuracy as well as the efficiency of the detection of an open fault in a multi-phase electric machine by the system can be further enhanced.

According to a further embodiment of the invention, a vehicle is provided, which comprises a system for detecting an open phase fault in a multi-phase electric machine as described above.

Thus, a vehicle is provided, which comprises a system for detecting an open phase fault in a multi-phase electric machine that does not require any additional hardware components to facilitate the detection of an open phase fault in a multi-phase electric machine of the vehicle, except a phase current measurement device for measuring at least one current value of each phase of the multi-phase electric machine, optionally a respective acquisition device for converting the measured values into digital signals, and an electronic control unit for processing the measured values in order to detect whether there is an open phase fault. Furthermore, no other input parameters than the phase currents are required to facilitate the detection of an open phase fault by the system of the vehicle. Thus, a vehicle with an improved system for detecting an open phase fault in a multi-phase electric machine is provided, which facilitates the detection of an open phase fault in a multi-phase electric machine with a low number of hardware components and input parameters. Therein, the vehicle can for example be a hybrid electric vehicle.

Embodiments of the invention will now be described with reference to the drawings.

Figure 1    illustrates a common three-phase motor;

Figure 2    illustrates a block diagram of a system for detecting an open phase fault in a multi-phase electric machine, according to a first embodiment of the invention;

Figure 3    illustrates a block diagram of a system for detecting an open phase fault in a multi-phase electric machine, according to a second embodiment of the invention;

Figure 4    illustrates a flow chart of a method for detecting an open phase fault in a multi-phase electric machine, according to embodiments of the invention.

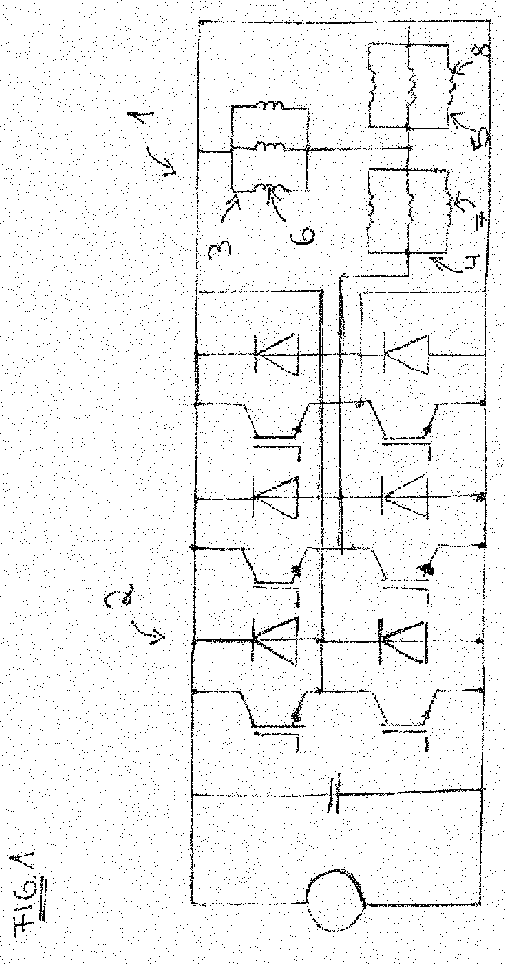

Figure 1 illustrates a common three-phase motor 1.

In particular, Fig. 1 shows a three-phase motor 1, which can be for example a synchronous or induction-type motor as known in the art, and a power or voltage-source inverter 2.

The three-phase motor 1 shown in Fig.1 includes three sets of phase windings 3,4,5, wherein each of the phase windings 3,4,5 includes conductive windings or coils 6, 7, 8, wherein each of the phase windings 3,4,5 carries a respective first, second and third phase.

Therein, an open phase of the three-phase motor 1 is that one phase current on the three-phase motor 1 may be lacked. Such an open phase fault could cause an over current on the other two motor phases which can lead to an unpredictable torque behavior, thereby for example threatening the safety of passengers in a hybrid electric vehicle where the three-phase motor is used. Therefore, open phase detection of the three-phase alternating currents is necessary.

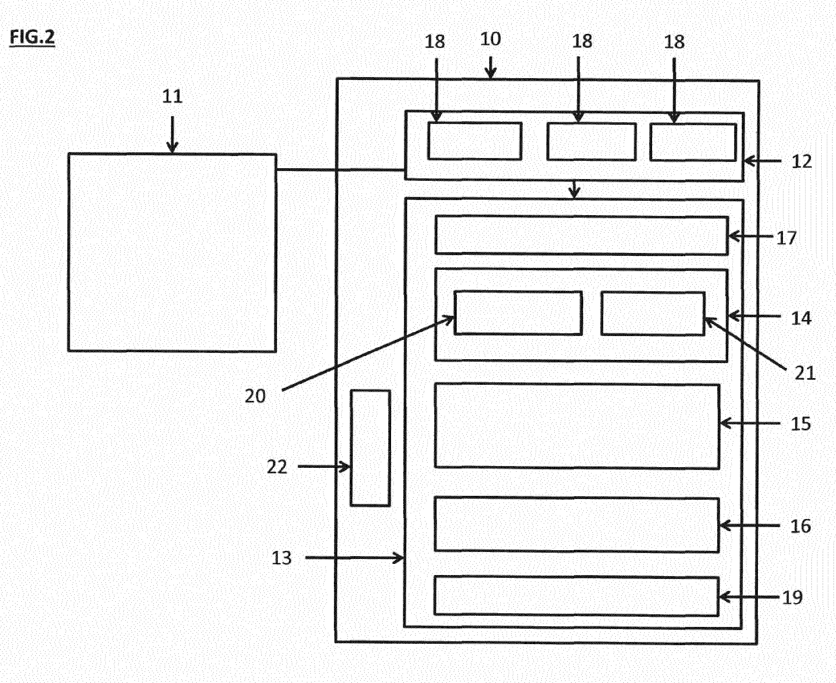

Figure 2 illustrates a block diagram of a system 10 for detecting an open phase fault in a multi-phase electric machine 11, according to a first embodiment of the invention.

According to the embodiment shown in Fig. 2, the system 10 comprises a phase current measurement device 12 coupled to the multi-phase electric machine 11 for measuring at least one current value of each phase of the multi-phase electric machine 11 and an electronic control unit 13 for detecting an open phase fault in the multi-phase electric machine 11, wherein the electronic control unit 13 comprises a first determining means 14 for determining, for always two phases of the multi-phase electric machine 11, a phase delay between two phases based on the measured current values, a second determining means 15 for determining if a determined phase delay between two phases exceeds a predetermined threshold, and a detecting means 16 for detecting that there is an open phase fault if a determined phase delay between two phases exceeds a predetermined threshold.

There is further shown an acquisition device 17 for converting the measured values into digital signals for further processing in the electronic control unit 13.

Thus, a system 10 for detecting an open phase fault in a multi-phase electric machine 11 is shown, which does not require any additional hardware components to facilitate the detection of an open phase fault in the multi-phase electric machine 11, except a phase current measurement device 12 for measuring at least one current value of each phase of the multi-phase electric machine 11, a respective acquisition device 17 for converting the measured values into digital signals, and an electronic control unit 13 for processing the measured values in order to detect whether there is an open phase fault. Furthermore, no other input parameters than the phase currents are required to facilitate the detection of an open phase fault by the system. Thus, an improved system for detecting an open phase fault in a multi-phase electric machine 11 is provided, which facilitates the detection of an open phase fault in the multi-phase electric machine 11 with a low number of hardware components and input parameters.

According to the embodiment shown in Fig. 2, the acquisition device 17 is integrated within the electronic control unit 13. However, the acquisition device can be a standalone device, too. Also, the phase current measurement device can be integrated into the electronic control unit, too.

As shown in Fig. 2, the phase current measurement device 12 further comprises hall sensors 18. That the phase current measurement device comprises hall sensors should merely be understood as an example, however, and the phase current measurement device can comprise any other device capable of measuring current values of a phase of a multi-phase electric machine, for example shunt resistors, too.

Further, the shown electronic control unit 13 further comprises a transferring means 19 for transferring the multi-phase electric machine into a safe state, if an open phase fault is detected. Therein, the transferring means 19 can for example comprise a means for stopping generating a driving signal for the multi-phase electric machine 11 and/or a warning means for outputting corresponding alarm information.

The shown phase current measurement device 12 is further configured to measure a plurality of current values of each phase of the multi-phase electric machine.

According to the embodiment shown in Fig. 2, the first determining means 14 comprises a first calculating means 20 for calculating a cross-correlation coefficient between the plurality of current values of a first phase of the two phases and the plurality of current values of a second phase of the two phases, and a second calculating means 21 for calculating an arc-cosine of the calculated cross-correlation coefficient in order to obtain a phase angle between the two phases, and the second determining means 15 is configured to use a debouncing algorithm to determine whether the phase angle between the two phases exceeds a specified angle for an amount of time. In particular, code for an algorithm for calculating a cross-correlation coefficient, code for an algorithm for performing an arc-cosine function and code for a debouncing algorithm are stored in a memory 22, which is accessible by the first calculating means 20, the second calculating means 21 and the second determining means 15.

For example, in case of a three-phase motor, the cross-correlation coefficient provides a measure of the linear correlation between each measured phase currents pair $(y_1, y_2)$, $(y_1, y_3)$, $(y_2, y_3)$, wherein $y_1$ are a plurality of measured current values of a first phase of the three-phase motor, $y_2$ are a plurality of measured current values of a second phase of the three-phase motor and $y_3$ are a plurality of measured current values of a third phase of the three-phase motor.

Therein, the cross-correlation coefficient between the plurality of current values of the first phase and the plurality of current values of the second phase can be calculated according to the following equation:

$$r_{y_1 y_2} = \frac{\text{cov}(y_1, y_2)}{\sigma_{y_1} \sigma_{y_2}}$$

(1)

wherein

$$\text{cov}(y_1, y_2) = \sum_{k=0}^{M-1} \left[ y_1(k) - \bar{y}_1 \right] \left[ y_2(k) - \bar{y}_2 \right]$$

(2)

is the covariance between phase currents $y_1$ and $y_2$.

$\bar{y}_1$ and $\bar{y}_2$ are defined as the mean values of the phase currents $y_1$ and $y_2$ over M samples.

The standard deviations of the phase currents $y_1$ and $y_2$ are defined by (3) and (4) respectively:

$$\sigma_{y_1} = \sqrt{\sum_{k=0}^{M-1} \left[ y_1(k) - \overline{y}_1 \right]^2}$$

$$(3)$$

$$\sigma_{y_2} = \sqrt{\sum_{k=0}^{M-1} \left[ y_2(k) - \overline{y}_2 \right]^2}$$

$$(4)$$

Correspondingly, the cross-correlation coefficient between the phase currents $y_1$ and $y_3$ can be calculated as follows:

$$r_{y_1 y_3} = \frac{\mathrm{cov}(y_1, y_3)}{\sigma_{y_1} \sigma_{y_3}}$$

$$(5)$$

where

$$\mathrm{cov}(y_1, y_3) = \sum_{k=0}^{M-1} \left[ y_1(k) - \overline{y}_1 \right]\left[ y_3(k) - \overline{y}_3 \right]$$

$$(6)$$

is the covariance between phase currents $y_1$ and $y_3$. $y_3$ is defined as the mean value of the phase current $y_3$ over M samples.

The standard deviations of the phase currents $y_3$ is defined by:

$$\sigma_{y_3} = \sqrt{\sum_{k=0}^{M-1} \left[ y_3(k) - \overline{y}_3 \right]^2}$$

$$(7)$$

Correspondingly, the cross-correlation coefficient between the phase currents $y_2$ and $y_3$ can be calculated as follows:

$$r_{y_2 y_3} = \frac{\text{cov}(y_2, y_3)}{\sigma_{y_2} \sigma_{y_3}}$$

$$(8)$$

where

$$\text{cov}(y_2, y_3) = \sum_{k=0}^{M-1} \left[ y_2(k) - \overline{y}_2 \right] \left[ y_3(k) - \overline{y}_3 \right]$$

$$(9)$$

is the covariance between the phase currents $y_2$ and $y_3$.

Therein, the mean values $\overline{y}_1$, $\overline{y}_2$ and $\overline{y}_3$ can be dynamically calculated (i.e. as the phase currents samples are measured and, thus, arrive), by using three first order discrete low pass filter algorithms. The filters can have a time constant defined by $T_m$ and gain $k_m$=1. The purpose of these three filter is to approximate the DC component (average/mean) of the phase currents by filtering the high frequency components and letting only the near to 0 frequency components pass.

The filter difference equations can be obtained by using the backward Euler method for discretization as it can be seen in (10). However other methods for discretization could also be used, such as the forward Euler method for discretization or the Tustin method.

$$\overline{y}_1(k) = k_m a_m y_1(k) + \overline{y}_1(k-1) - a_m \overline{y}_1(k-1)$$
$$\overline{y}_2(k) = k_m a_m y_2(k) + \overline{y}_2(k-1) - a_m \overline{y}_2(k-1)$$
$$\overline{y}_3(k) = k_m a_m y_3(k) + \overline{y}_3(k-1) - a_m \overline{y}_3(k-1)$$

$$(10)$$

where

$$a_m = \frac{T_s}{T_s + T_m}$$

$$(11)$$

Therein, $T_s$ is the algorithm recurrence time and the sampling time of the phase currents.

Further, the differences $\Delta y_1$, $\Delta y_2$ and $\Delta y_3$ of the phase currents from the mean values $\overline{y}_1$, $\overline{y}_2$ and $\overline{y}_3$ are calculated as in (12):

$$\Delta y_1(k) = \overline{y}_1(k) - y_1(k)$$
$$\Delta y_2(k) = \overline{y}_2(k) - y_2(k)$$
$$\Delta y_3(k) = \overline{y}_3(k) - y_3(k)$$

$$(12)$$

Following, the sample covariances $cov(y_1,y_2)$, $cov(y_1,y_3)$ and $cov(y_2,y_3)$ are dynamically calculated (i.e. the sample covariances $cov(y_1,y_2)$, $cov(y_1,y_3)$, $cov(y_2,y_3)$ are updated with the arrival of the phase current samples $y_1$, $y_2$, $y_3$), based on three first order discrete low pass filter algorithms with the time constant $T_c$ and gain $k_c = 1$.

$$\text{cov } y_1 y_2(k) = a_c k_c \Delta y_1(k) \Delta y_2(k) +$$
$$+ \text{cov } y_1 y_2(k-1) - a_c \text{ cov } y_1 y_2(k-1)$$
$$\text{cov } y_1 y_3(k) = a_c k_c \Delta y_1(k) \Delta y_3(k) +$$
$$+ \text{cov } y_1 y_3(k-1) - a_c \text{ cov } y_1 y_3(k-1)$$

$$\text{cov } y_2 y_3(k) = a_c k_c \Delta y_2(k) \Delta y_3(k) +$$
$$+ \text{cov } y_2 y_3(k-1) - a_c \text{ cov } y_2 y_3(k-1)$$

$$(13)$$

where

$$a_c = \frac{T_s}{T_s + T_c}$$

$$(14)$$

is the low pass filter paramater.

The standard deviation of the phase currents $y_1$, $y_2$, $y_3$ can be dynamically calculated (i.e. the standard deviations of the phase currents $y_1$, $y_2$, $y_3$ are updated with the arrival of the phase current samples) based on three first order discrete low pass filter algorithms with the time constant $T_c$ and gain $k_s = 1.1547$.

Therein, the absolute values of the differences namely $|\Delta y_1|$, $|\Delta y_2|$ and $|\Delta y_3|$ can be used as filter input to recursively calculate the standard deviations $\sigma_1$, $\sigma_2$, $\sigma_3$. Therefore:

$$\sigma_1(k) = k_s a_c |\Delta_1(k)| + \sigma_1(k-1) - a_c \sigma_1(k-1)$$
$$\sigma_2(k) = k_s a_c |\Delta_2(k)| + \sigma_2(k-1) - a_c \sigma_2(k-1)$$
$$\sigma_3(k) = k_s a_c |\Delta_1(k)| + \sigma_3(k-1) - a_c \sigma_3(k-1)$$

$$(15)$$

The cross-correlation coefficients between the phase currents at time k can then be updated $r_{y1y2}(k)$ according to (1), (5) and (8). Therefore:

$$r_{y1y2}(k) = \frac{\operatorname{cov} y_1 y_2(k)}{\sigma_1(k)\sigma_2(k)}$$

$$r_{y1y3}(k) = \frac{\operatorname{cov} y_1 y_2(k)}{\sigma_1(k)\sigma_2(k)}$$

$$r_{y2y3}(k) = \frac{\operatorname{cov} y_1 y_2(k)}{\sigma_1(k)\sigma_2(k)}$$

$$(16)$$

The phase angles between phases $y_1$ and $y_2$, $y_1$ and $y_3$, $y_2$ and $y_3$, in radians, can then be obtained by calculating the arc-cosine function of the cross-correlation coefficients $r_{y1y2}$, $r_{y1y3}$ and $r_{y2y3}$, respectively. Hence,

$$\varphi_{y1y2}(k) = \arccos(r_{y1y2}(k))$$

$$\varphi_{y1y3}(k) = \arccos(r_{y1y3}(k))$$

$$\varphi_{y2y3}(k) = \arccos(r_{y2y3}(k))$$

$$(17)$$

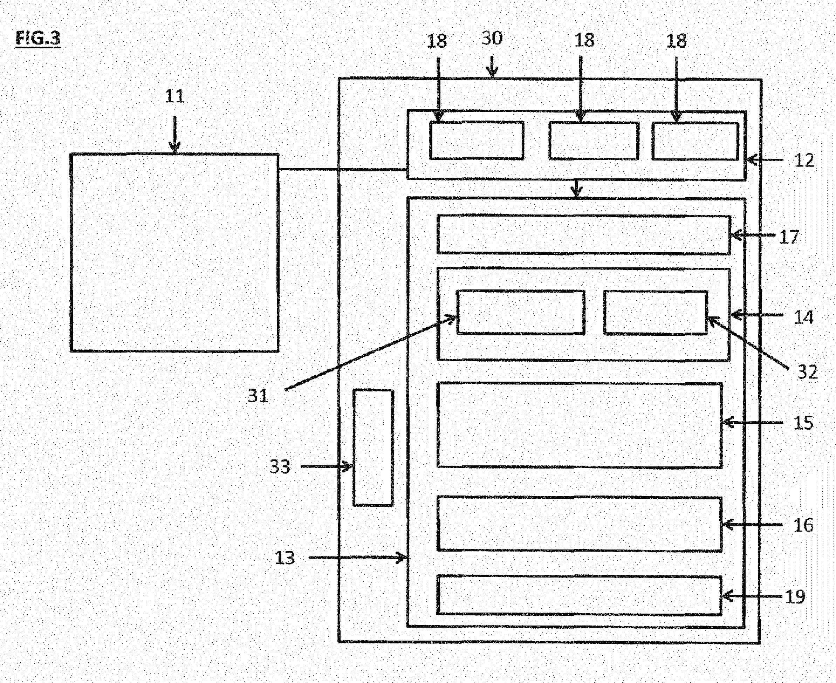

Figure 3 illustrates a block diagram of a system 30 for detecting an open phase fault in a multi-phase electric machine 11, according to a second embodiment of the invention. Therein, identical structural features as within the embodiment shown in Fig. 2 are identified by identical reference symbols.

According to Fig. 3, the difference between the system 30 of the shown second embodiment and the system 10 of the first embodiment is that, according to the second embodiment, the determination is based on a phase time delay instead of a phase angle delay and, therefore, that the phase current measurement device 12 is configured to measure the plurality of current values of each phase of the multi-phase electric machine over a predetermined sampling period, and that the first determining means 14 comprises a third calculating means 31 for calculating a cross-correlation between a plurality of current values of a first phase of the two phases and a plurality of current values of a second phase of the two phases and a fourth calculating means 32 for maximizing the cross correlation in order to obtain a time delay between the two phases. In particular, code for an algorithm for calculating a cross-correlation and code for an algorithm for maximizing the cross-correlation are stored in a memory 33, which is accessible by the third calculating means 31 and the fourth calculating means 32.

Therein, the predetermined sampling period is based on a maximum frequency of the electric machine.

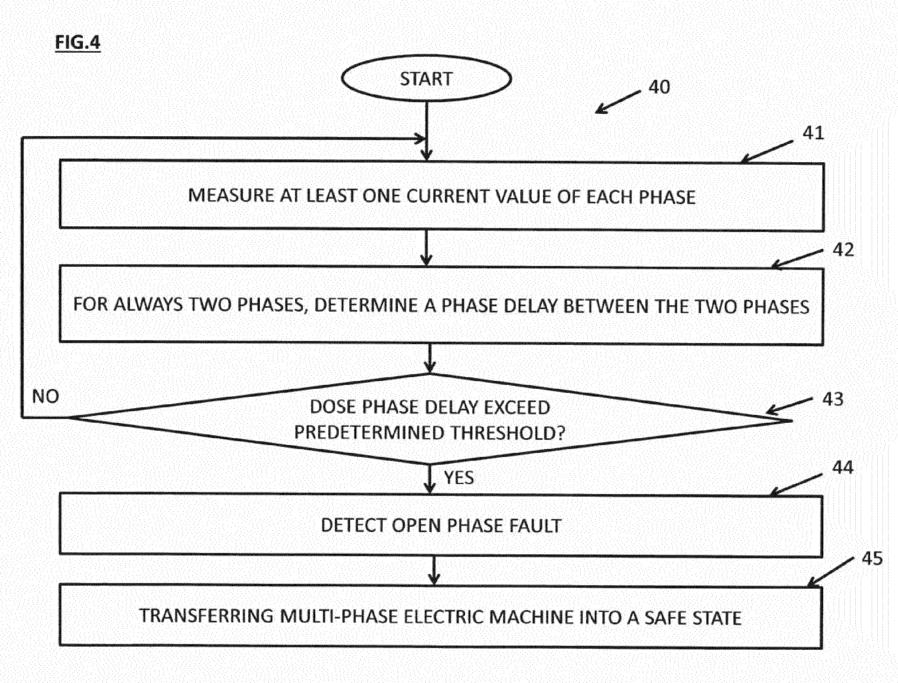

Figure 4 illustrates a flow chart of a method 40 for detecting an open phase fault in a multi-phase electric machine, according to embodiments of the invention.

Therein, as shown in Fig. 4, the method 40 comprises the following steps: In a first step 41, at least one current value of each phase of the multi-phase electric machine is measured. In a second step 42, for always two phases of the multi-phase electric machine, a phase delay between the two phases is determined based on the measured current values, and in a third step 43, it is determined if a determined phase delay between two phases exceeds a predetermined threshold. Further, in a fourth step 44, it is detected that there is an open phase fault, if a determined phase delay between two phases exceeds a predetermined threshold.

Therein, if it is determined in step 43 that a determined phase delay between two phases exceeds a predetermined threshold, the method continues with step 44, where it is detected that there is an open phase fault. Otherwise, if it is determined in step 43 that no determined phase delay between two phases exceeds a predetermined threshold, steps 41 and 42 are repeated.

Thus, a method 40 for detecting an open phase fault in a multi-phase electric machine is shown, which does not require any other input parameters than the phase currents and is, therefore, independent of other input parameters. Further, no additional hardware components are required to implement the method, except a phase current measurement device for measuring at least one current value of each phase of the multi-phase electric machine, optionally a respective acquisition device for converting the measured values into digital signals, and a processing device for processing the measured values in order to detect whether there is an open phase fault. Thus, an improved method 40 for detecting an open phase fault in a multi-phase electric machine is provided, which is feasible with a low number of hardware components and input parameters.

According to the embodiments shown in Fig. 4, the method further comprises the step 45 of transferring the multi-phase electric machine into a safe state, if it is detected that there is an open phase fault.

List of reference signs

| | |
|---|---|
| 1 | three-phase motor |
| 2 | voltage-source inverter |
| 3 | phase winding |
| 4 | phase winding |
| 5 | phase winding |
| 6 | coil |
| 7 | coil |
| 8 | coil |
| 10 | system |
| 11 | multi-phase electric machine |
| 12 | phase current measurement device |
| 13 | electronic control unit |
| 14 | first determining means |
| 15 | second determining means |
| 16 | detecting means |
| 17 | acquisition means |
| 18 | hall sensor |
| 19 | transferring means |
| 20 | first calculating means |
| 21 | second calculating means |
| 22 | memory |
| 30 | system |
| 31 | third calculating means |
| 32 | fourth calculating means |
| 33 | memory |
| 40 | method |
| 41 | step |
| 42 | step |
| 43 | step |
| 44 | step |
| 45 | step |

**Claims**

1. Method for detecting an open phase fault in a multi-phase electric machine, wherein the method (40) comprises the step of:

    - measuring at least one current value of each phase of the multi-phase electric machine (41), **characterized in that** the method further comprises:
    - for always two phases of the multi-phase electric machine, determining a phase delay between the two phases based on the measured current values (42);
    - determining if a determined phase delay between two phases exceeds a predetermined threshold (43);
    - if a determined phase delay between two phases exceeds a predetermined threshold, detecting that there is an open phase fault (44).

2. Method according to claim 1, wherein the method (40) further comprises the step of:

    - transferring the multi-phase electric machine into a safe state, if it is detected that there is an open phase fault (45).

3. Method according to claim 1 or 2, wherein the step of measuring at least one current value of each phase of the multi-phase electric machine (41) comprises measuring a plurality of current values of each phase of the multi-phase electric machine.

4. Method according to claim 3, wherein the step of, for always two phases of the multi-phase electric machine, determining a phase delay between the two phases based on the measured current values (42) comprises calculating a cross-correlation coefficient between a plurality of current values of a first phase of the two phases and a plurality of current values of a second phase of the two phases, and calculating an arc-cosine of the calculated cross-correlation coefficient in order to obtain a phase angle between the two phases, and wherein the step of determining if a determined phase delay between two phases exceeds a predetermined threshold comprises using a debouncing algorithm to determine whether the phase angle between the two phases exceeds a specified angle for an amount of time.

5. Method according to claim 3, wherein the plurality of current values of each phase of the multi-phase electric machine are measured over a predetermined sampling period, wherein the step of, for always two phases of the multi-phase electric machine, determining a phase delay between the two phases based on the measured current values (42) comprises calculating a cross-correlation between a plurality of current values of a first phase of the two phases and a plurality of current values of a second phase of the two phases, and maximizing the cross correlation in order to obtain a time delay between the two phases.

6. Method according to claim 5, wherein the predetermined sampling period is based on a maximum frequency of the electric machine.

7. A computer program product, comprising code tangibly embodied thereon, that when executed on a processor, causes the processor to perform a method (40) according to one of claims 1 to 6.

8. System for detecting an open phase fault in a multi-phase electric machine (11), comprising a phase current measurement device (12) coupled to the multi-phase electric machine (11) for measuring at least one current value of each phase of the multi-phase electric machine (11) and an electronic control unit (13) for detecting an open phase fault in the multi-phase electric machine (11), **characterized in that** the electronic control unit (13) comprises a first determining means (14) for determining, for always two phases of the multi-phase electric machine (11), a phase delay between two phases based on the measured current values, a second determining means (15) for determining if a determined phase delay between two phases exceeds a predetermined threshold, and a detecting means (16) for detecting that there is an open phase fault if a determined phase delay between two phases exceeds a predetermined threshold.

9. System according to claim 8, wherein the phase current measurement device (12) comprises at least one hall sensor (18) and/or at least one shunt resistor.

10. System according to claim 8 or 9, wherein the electronic control unit (13) further comprises a transferring means (19) for transferring the multi-phase electric machine (11) into a safe state, if an open phase fault is detected.

11. System according to one of claims 8 to 10, wherein the phase current measurement device is configured to measure a plurality of current values of each phase of the multi-phase electric machine.

12. System according to claim 11, wherein the first determining means (14) comprises a first calculating means (20) for calculating a cross-correlation coefficient between a plurality of current values of a first phase of the two phases and a plurality of current values of a second phase of the two phases, and a second calculating means (21) for calculating an arc-cosine of the calculated cross-correlation coefficient in order to obtain a phase angle between the two phases, and wherein the second determining means (15) is configured to use a debouncing algorithm to determine whether the phase angle between the two phases exceeds a specified angle for an amount of time.

13. System according to claim 11, wherein the phase current measurement device (12) is configured to measure the plurality of current values of each phase of the multi-phase electric machine (11) over a predetermined sampling period, and wherein the first determining means (14) comprises a third calculating means (31) for calculating a cross-correlation between a plurality of current values of a first phase of the two phases and a plurality of current values of a second phase of the two phases, and a fourth calculating means (32) for maximizing the cross correlation in order to obtain a time delay between the two phases.

14. System according to claim 13, wherein the predetermined sampling period is based on a maximum frequency of the multi-phase electric machine (11).

15. Vehicle comprising a system (10, 30) for detecting an open phase fault in a multi-phase electric machine according to one of claims 8 to 14.

**Patentansprüche**

1. Verfahren zum Detektieren eines Phasenleiterbruchfehlers in einer Mehrphasen-Elektromaschine, wobei das Verfahren (40) den folgenden Schritt aufweist:

   - Messen mindestens eines Stromwerts von jeder Phase der Mehrphasen-Elektromaschine (41), **dadurch gekennzeichnet, dass** das Verfahren ferner Folgendes aufweist:
   - für immer zwei Phasen der Mehrphasen-Elektromaschine, Bestimmen einer Phasenverzögerung zwischen den zwei Phasen auf der Grundlage der gemessenen Stromwerte (42);
   - Bestimmen, ob eine bestimmte Phasenverzögerung zwischen zwei Phasen einen vorbestimmten Schwellenwert übersteigt (43) ;
   - falls eine bestimmte Phasenverzögerung zwischen zwei Phasen einen vorbestimmten Schwellenwert übersteigt, Detektieren, dass ein Phasenleiterbruchfehler vorliegt (44) .

2. Verfahren nach Anspruch 1, wobei das Verfahren (40) ferner den folgenden Schritt aufweist:

   - Versetzen der Mehrphasen-Elektromaschine in einen sicheren Zustand, falls detektiert wird, dass ein Phasenleiterbruchfehler vorliegt (45).

3. Verfahren nach Anspruch 1 oder 2, wobei der Schritt des Messens mindestens eines Stromwerts von jeder Phase der Mehrphasen-Elektromaschine (41) Messen mehrerer Stromwerte von jeder Phase der Mehrphasen-Elektromaschine aufweist.

4. Verfahren nach Anspruch 3, wobei der Schritt des, für immer zwei Phasen der Mehrphasen-Elektromaschine, Bestimmens einer Phasenverzögerung zwischen den zwei Phasen auf der Grundlage der gemessenen Stromwerte (42), Berechnen eines Kreuzkorrelationskoeffizienten zwischen mehreren Stromwerten einer ersten Phase der zwei Phasen und mehreren Stromwerten einer zweiten Phase der zwei Phasen und Berechnen eines Arcuscosinus des berechneten Kreuzkorrelationskoeffizienten, um einen Phasenwinkel zwischen den zwei Phasen zu erhalten, aufweist, und wobei der Schritt des Bestimmens, ob eine bestimmte Phasenverzögerung zwischen zwei Phasen einen vorbestimmten Schwellenwert übersteigt, Verwenden eines Debouncing-Algorithmus zum Bestimmen, ob der Phasenwinkel zwischen den zwei Phasen für einen Zeitraum einen vorgegebenen Winkel übersteigt, aufweist.

5. Verfahren nach Anspruch 3, wobei die mehreren Stromwerte von jeder Phase der Mehrphasen-Elektromaschine über eine vorbestimmte Abtastperiode gemessen werden, wobei der Schritt des, für immer zwei Phasen der Mehrphasen-Elektromaschine, Bestimmens einer Phasenverzögerung zwischen den zwei Phasen auf der Grundlage der gemessenen Stromwerte (42), Berechnen einer Kreuzkorrelation zwischen mehreren Stromwerten einer ersten Phase der zwei Phasen und mehreren Stromwerten einer zweiten Phase der zwei Phasen und Maximieren der Kreuzkorrelation, um eine Zeitverzögerung zwischen den zwei Phasen zu erhalten, aufweist.

6. Verfahren nach Anspruch 5, wobei die vorbestimmte Abtastperiode auf einer Maximalfrequenz der Elektromaschine basiert.

7. Computerprogrammprodukt, das darin greifbar umgesetzten Code aufweist, der bei Ausführung in einem Prozessor den Prozessor zum Durchführen eines Verfahrens (40) nach einem der Ansprüche 1 bis 6 veranlasst.

8. System zum Detektieren eines Phasenleiterbruchfehlers in einer Mehrphasen-Elektromaschine (11), umfassend eine Phasenstrommessvorrichtung (12), gekoppelt mit der Mehrphasen-Elektromaschine (11), zum Messen mindestens eines Stromwerts von jeder Phase der Mehrphasen-Elektromaschine (11), und eine Elektroniksteuereinheit (13) zum Detektieren eines Phasenleiterbruchfehlers in der Mehrphasen-Elektromaschine (11), **dadurch gekennzeichnet, dass** die Elektroniksteuereinheit (13) ein erstes Bestimmungsmittel (14) zum Bestimmen, für immer zwei Phasen der Mehrphasen-Elektromaschine (11), einer Phasenverzögerung zwischen zwei Phasen auf der Grundlage der gemessenen Stromwerte, ein zweites Bestimmungsmittel (15) zum Bestimmen, ob eine bestimmte Phasenverzögerung zwischen zwei Phasen einen vorbestimmten Schwellenwert übersteigt, und ein Detektionsmittel (16) zum Detektieren, dass ein Phasenleiterbruchfehler vorliegt, falls eine bestimmte Phasenverzögerung zwischen zwei Phasen einen vorbestimmten Schwellenwert übersteigt, umfasst.

9. System nach Anspruch 8, wobei die Phasenstrommessvorrichtung (12) mindestens einen Hall-Sensor (18) und/oder mindestens einen Nebenschlusswiderstand umfasst.

10. System nach Anspruch 8 oder 9, wobei die Elektroniksteuereinheit (13) ferner ein Versetzungsmittel (19) zum Versetzen der Mehrphasen-Elektromaschine (11) in einen sicheren Zustand, falls ein Phasenleiterbruchfehler detektiert wird, umfasst.

11. System nach einem der Ansprüche 8 bis 10, wobei die Phasenstrommessvorrichtung ausgebildet ist zum Messen mehrerer Stromwerte von jeder Phase der Mehrphasen-Elektromaschine.

12. System nach Anspruch 11, wobei das erste Bestimmungsmittel (14) ein erstes Berechnungsmittel (20) zum Berechnen eines Kreuzkorrelationskoeffizienten zwischen mehreren Stromwerten einer ersten Phase der zwei Phasen und mehreren Stromwerten einer zweiten Phase der zwei Phasen und ein zweites Berechnungsmittel (21) zum Berechnen eines Arcuscosinus des berechneten Kreuzkorrelationskoeffizienten, um einen Phasenwinkel zwischen den zwei Phasen zu erhalten, umfasst, und wobei das zweite Bestimmungsmittel (15) ausgebildet ist zum Verwenden eines Debouncing-Algorithmus zum Bestimmen, ob der Phasenwinkel zwischen den zwei Phasen für einen Zeitraum einen vorgegebenen Winkel übersteigt.

13. System nach Anspruch 11, wobei die Phasenstrommessvorrichtung (12) ausgebildet ist zum Messen der mehreren Stromwerte von jeder Phase der Mehrphasen-Elektromaschine (11) über eine vorbestimmte Abtastperiode, und wobei das erste Bestimmungsmittel (14) ein drittes Berechnungsmittel (31) zum Berechnen einer Kreuzkorrelation zwischen mehreren Stromwerten einer ersten Phase der zwei Phasen und mehreren Stromwerten einer zweiten Phase der zwei Phasen und ein viertes Berechnungsmittel (32) zum Maximieren der Kreuzkorrelation, um eine Zeitverzögerung zwischen den zwei Phasen zu erhalten, umfasst.

14. System nach Anspruch 13, wobei die vorbestimmte Abtastperiode auf einer Maximalfrequenz der Mehrphasen-Elektromaschine (11) basiert.

15. Fahrzeug, das ein System (10, 30) zum Detektieren eines Phasenleiterbruchfehlers in einer Mehrphasen-Elektromaschine nach einem der Ansprüche 8 bis 14 umfasst.

**Revendications**

1. Procédé de détection d'un défaut de phase ouverte dans une machine électrique polyphasée, le procédé (40) comportant l'étape consistant à :

- mesurer au moins une valeur de courant de chaque phase de la machine électrique polyphasée (41), **caractérisé en ce que** le procédé comporte en outre les étapes consistant :
- toujours pour deux phases de la machine électrique polyphasée, à déterminer un retard de phase entre les deux phases d'après les valeurs de courant mesurées (42) ;
- à déterminer si un retard de phase déterminé entre deux phases dépasse un seuil prédéterminé (43) ;
- si un retard de phase déterminé entre deux phases dépasse un seuil prédéterminé, à détecter qu'il existe un défaut de phase ouverte (44).

2. Procédé selon la revendication 1, le procédé (40) comportant en outre l'étape consistant à :

- transférer la machine électrique polyphasée vers un état sûr, s'il est détecté qu'il existe un défaut de phase ouverte (45).

3. Procédé selon la revendication 1 ou 2, l'étape de mesure d'au moins une valeur de courant de chaque phase de la machine électrique polyphasée (41) comportant la mesure d'une pluralité de valeurs de courant de chaque phase de la machine électrique polyphasée.

**4.** Procédé selon la revendication 3, l'étape consistant, toujours pour deux phases de la machine électrique polyphasée, à déterminer un retard de phase entre les deux phases d'après les valeurs de courant mesurées (42) comportant le calcul d'un coefficient de corrélation croisée entre une pluralité de valeurs de courant d'une première phase parmi les deux phases et une pluralité de valeurs de courant d'une seconde phase parmi les deux phases, et le calcul d'un arc cosinus du coefficient calculé de corrélation croisée afin d'obtenir un angle de phase entre les deux phases, et l'étape consistant à déterminer si un retard de phase déterminé entre deux phases dépasse un seuil prédéterminé comportant l'utilisation d'un algorithme anti-rebond pour déterminer si l'angle de phase entre les deux phases dépasse un angle spécifié pendant un laps de temps.

**5.** Procédé selon la revendication 3, la pluralité de valeurs de courant de chaque phase de la machine électrique polyphasée étant mesurée sur une période d'échantillonnage prédéterminée, l'étape consistant, toujours pour deux phases de la machine électrique polyphasée, à déterminer un retard de phase entre les deux phases d'après les valeurs de courant mesurées (42) comportant le calcul d'une corrélation croisée entre une pluralité de valeurs de courant d'une première phase parmi les deux phases et une pluralité de valeurs de courant d'une seconde phase parmi les deux phases, et la maximisation de la corrélation croisée afin d'obtenir un retard temporel entre les deux phases.

**6.** Procédé selon la revendication 5, la période d'échantillonnage prédéterminée étant basée sur une fréquence maximum de la machine électrique.

**7.** Produit de programme informatique, comportant du code incorporé de façon tangible sur celui-ci qui, lorsqu'il est exécuté sur un processeur, amène le processeur à réaliser un procédé (40) selon l'une des revendications 1 à 6.

**8.** Système de détection d'un défaut de phase ouverte dans une machine électrique polyphasée (11), comportant un dispositif (12) de mesure de courant de phase couplé à la machine électrique polyphasée (11) servant à mesurer au moins une valeur de courant de chaque phase de la machine électrique polyphasée (11) et une unité (13) de commande électronique servant à détecter un défaut de phase ouverte dans la machine électrique polyphasée (11), **caractérisé en ce que** l'unité (13) de commande électronique comporte un premier moyen (14) de détermination servant à déterminer, toujours pour deux phases de la machine électrique polyphasée (11), un retard de phase entre deux phases d'après les valeurs de courant mesurées, un deuxième moyen (15) de détermination servant à déterminer si un retard de phase déterminé entre deux phases dépasse un seuil prédéterminé, et un moyen (16) de détection servant à détecter qu'il existe un défaut de phase ouverte si un retard de phase déterminé entre deux phases dépasse un seuil prédéterminé.

**9.** Système selon la revendication 8, le dispositif (12) de mesure de courant de phase comportant au moins un capteur (18) à effet Hall et/ou au moins une résistance de shunt.

**10.** Système selon la revendication 8 ou 9, l'unité (13) de commande électronique comportant en outre un moyen (19) de transfert servant à transférer la machine électrique polyphasée (11) vers un état sûr, si un défaut de phase ouverte est détecté.

**11.** Système selon l'une des revendications 8 à 10, le dispositif de mesure de courant de phase étant configuré pour mesurer une pluralité de valeurs de courant de chaque phase de la machine électrique polyphasée.

**12.** Système selon la revendication 11, le premier moyen (14) de détermination comportant un premier moyen (20) de calcul servant à calculer un coefficient de corrélation croisée entre une pluralité de valeurs de courant d'une première phase parmi les deux phases et une pluralité de valeurs de courant d'une seconde phase parmi les deux phases, et un deuxième moyen (21) de calcul servant à calculer un arc cosinus du coefficient calculé de corrélation croisée afin d'obtenir un angle de phase entre les deux phases, et le deuxième moyen (15) de détermination étant configuré pour utiliser un algorithme anti-rebond afin de déterminer si l'angle de phase entre les deux phases dépasse un angle spécifié pendant un laps de temps.

**13.** Système selon la revendication 11, le dispositif (12) de mesure de courant de phase étant configuré pour mesurer la pluralité de valeurs de courant de chaque phase de la machine électrique polyphasée (11) sur une période d'échantillonnage prédéterminée, et le premier moyen (14) de détermination comportant un troisième moyen (31) de calcul servant à calculer une corrélation croisée entre une pluralité de valeurs de courant d'une première phase parmi les deux phases et une pluralité de valeurs de courant d'une seconde phase parmi les deux phases, et un quatrième moyen (32) de calcul servant à maximiser la corrélation croisée afin d'obtenir un retard temporel entre les deux phases.

14. Système selon la revendication 13, la période d'échantillonnage prédéterminée étant basée sur une fréquence maximum de la machine électrique polyphasée (11).

15. Véhicule comportant un système (10, 30) de détection d'un défaut de phase ouverte dans une machine électrique polyphasée selon l'une des revendications 8 à 14.

FIG.1

FIG.2

FIG.3

**FIG.4**

START — 40

MEASURE AT LEAST ONE CURRENT VALUE OF EACH PHASE — 41

FOR ALWAYS TWO PHASES, DETERMINE A PHASE DELAY BETWEEN THE TWO PHASES — 42

DOSE PHASE DELAY EXCEED PREDETERMINED THRESHOLD? — 43

NO

YES

DETECT OPEN PHASE FAULT — 44

TRANSFERRING MULTI-PHASE ELECTRIC MACHINE INTO A SAFE STATE — 45

EP 3 156 811 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110089883 A1
- JP 2006025526 A
- EP 2913918 A1